# EUROPEAN PATENT APPLICATION

(11) **EP 4 261 614 A1**
(43) Date of publication of application: **18.10.2023**
(21) Application number: 23166211.5
(22) Date of filing: 31.03.2023
(51) Int. Cl.: G03F 1/24, G03F 1/38, G03F 1/80

(54) **REFLECTIVE PHOTOMASK BLANK, METHOD FOR MANUFACTURING REFLECTIVE PHOTOMASK, AND REFLECTIVE PHOTOMASK**

(30) Priority: 13.04.2022 JP 2022066238
(71) Applicant: Shin-Etsu Chemical Co., Ltd., Tokyo (JP)
(72) Inventor: SAKURAI, Keisuke, Joetsu-shi (JP); MIMURA, Shohei, Joetsu-shi (JP); ISHII, Takeshi, Joetsu-shi (JP)
(74) Representative: Mewburn Ellis LLP

(57) **Abstract**

A reflective photomask blank includes a substrate, a multilayer reflection film that is formed on the substrate and reflects exposure light being light in extreme ultraviolet range, a protection film that is formed on the multilayer reflection film to protect the multilayer reflection film, a light-absorbing film that is formed on the protection film and absorbs the exposure light, and a hard mask film that is formed on and in contact with the light-absorbing film and functions as a hard mask in pattering the light-absorbing film by dry etching. The hard mask film is constituted by a multilayer including a first layer and a second layer, the first layer is disposed at the side remotest from the substrate, and is composed of a material containing silicon and free of chromium, and the second layer is composed of a material containing chromium and free of silicon.

## Description

### TECHNICAL FIELD

The present invention relates to a reflective photomask that is used in manufacturing semiconductor devices, and a method of manufacturing a reflective photomask, and a reflective photomask blank that is used as a material for manufacturing a reflective photomask.

### BACKGROUND

It is required that projection exposure has high pattern resolution in accordance with miniaturization of semiconductor devices, particularly, with high integration of large-scale integrated circuits. So, a phase shift mask has been developed as a means for improving the resolution of a transfer pattern of a photomask. A principle of a phase shift method is that, by adjusting so as to invert a phase of transmitted light that has been passed through an opening of a phase shift film by about 180 degrees with respect to a phase of transmitted light that has been passed through the phase shift film portion adjacent to the opening, interference between the transmitted lights reduces a light intensity at the boundary of the opening and the portion adjacent to the opening. As a result, resolution of a transfer pattern and depth of focus are improved. A photomask using this principle is generally called a phase shift mask.

A most common phase shift mask blank, as a material for a phase shift mask, that is used for manufacturing a phase shift mask has a structure in which a phase shift film is laminated on a transparent substrate such as a glass substrate, and a film composed of a material containing chromium (Cr) are laminated on the phase shift film. The phase shift film usually has a phase shift of 175 to 185 degrees and a transmittance of about 6 to 30% with respect to exposure light, and a mainstream phase shift film is a film composed of a material containing silicon (Si), particularly a material containing molybdenum (Mo) and silicon (Si). Further, a film composed of a material containing chromium is adjusted so as to have a thickness that provides a desired optical density together with the phase shift film, and the film composed of a material containing chromium is generally used as a light-shielding film, and is also used as a hard mask film in etching of the phase shift film.

In particular, a general method for manufacturing a phase shift mask from a phase shift mask blank in which a phase shift film composed of a material containing silicon, and a light-shielding film composed of a material containing chromium are formed in this order on a transparent substrate by patterning the phase shift film is as follows. First, a resist film is formed on the light-shielding film composed of a material containing chromium of the phase shift mask blank, and a resist pattern is formed by drawing a pattern onto the resist film by light or an electron beam, and developing. Next, the light-shielding film composed of a material containing chromium is etched with using the resist pattern as an etching mask and a chlorine-based gas to form a pattern of the light-shielding film. Further, the phase shift film composed of a material containing silicon is etched with using the pattern of the light-shielding film as an etching mask and a fluorine-based gas to form a pattern of the phase shift film. Then, the resist pattern is removed, and the pattern of the light-shielding film is removed by etching using a chlorine-based gas.

In this case, the light-shielding film is remained at the portion of the phase shift film outside of the portion in which the pattern (circuit pattern) of the phase shift film is formed, and a light-shielding portion (light-shielding pattern) having an optical density of not less than 3 in the combination of the phase shift film and the light-shielding film is provided at the outer periphery portion of the phase shift film. This is to prevent irradiation of leaked exposure light at the outer periphery portion of the phase shift film to the resist film formed on adjacent chips in the wafer through the portion located outside of the circuit pattern in transferring circuit pattern to a wafer by a wafer exposure device. In a general method for forming such a light-shielding pattern, after forming a pattern of the phase shift film and removing a resist pattern, a resist film is anew formed and a resist pattern remained on the outer periphery portion of the phase shift film is formed by drawing a pattern and developing. Then, a film composed of a material containing chromium is etched with using the resist pattern as an etching mask to form the light-shielding film remained on the outer periphery portion of the phase shift film.

A mainstream etching for s phase shift mask that requires pattern formation with highly accurate is dry etching using gas plasma. Dry etching using a chlorine-based gas (chlorine-based dry etching) is used for a film composed of a material containing chromium, and dry etching using a fluorine-based gas (fluorine -based dry etching) is used for a film composed of a material containing silicon or a film composed of a material containing molybdenum and silicon. Particularly, it is known that, in dry etching for a film composed of a material containing chromium, chemical reactivity and etching rate are increased with using an etching gas being an etching gas of chlorine gas (Cl₂ gas) mixed with 10 to 25 vol% of oxygen gas (O₂ gas).

According to miniaturization of circuit patterns, a circuit pattern of a phase shift mask also requires a technique for fine pattern formation. Particularly, an assist pattern of a line pattern, which assists resolution of main pattern of the phase shift mask, is needed to form smaller than the main pattern so as not to be transferred onto a wafer when a circuit pattern is transferred onto the wafer by a wafer exposure device. In the phase shift mask of the generation in which a half pitch of line and space patterns of the circuit on the wafer is 10 nm, a line width of the assist pattern of the line pattern of the circuit on the phase shift mask is required to be about 40 nm.

A chemically amplified resist that can form fine patterns consists of a base resin, an acid generator, a surfactant and others, and can be applied to many reactions in which the acid generated by exposure acts as a catalyst. Therefore, the chemically amplified resists can have high sensitivity, and by using a chemically amplified resist, it is possible to form a mask pattern such as a fine phase shift film pattern having a line width of not more than 0.1 µm. The resist is applied onto the photomask blank by spin coating using a resist coater.

A thickness of the resist film used for an advanced phase shift mask blank is 100 to 150 nm. The reason why it is difficult to form a finer assist pattern on a phase shift mask is that since the resist pattern for forming the assist pattern formed on a light-shielding film composed of material containing chromium has a high aspect ratio, in developing process for forming the resist pattern, the assist pattern collapses due to impact of a developing solution or impact of pure water during rinsing process.

Therefore, it has been considered to lower a height-to-width ratio (aspect ratio) of the resist pattern for reducing influence of the impact of the developing solution or pure water. In that case, the resist film will be thinned. However, when the resist film is thin, if the resist film is lost during dry etching of the light-shielding film composed of a material containing chromium, resulting in pinhole defects generated in the light-shielding film composed of the material containing chromium. As a result, when a phase shift film is dry-etched using a light-shielding film composed of a material containing chromium as an etching mask, plasma in etching of the phase shift film reaches to the phase shift film through the pinholes, resulting in pinhole defects formed also in the phase shift film. Accordingly, a phase shift mask cannot be manufactured normally.

To solve this problem, a hard mask film composed of a material containing silicon has been further provided on the light-shielding film composed of a material containing chromium. In this case, the hard mask film composed of a material containing silicon is a thin film having a thickness of 5 to 15 nm, and a thickness of the resist film formed on the hard mask film has been thinned to 80 to 110 nm.

In the case that the light-shielding film composed of a material containing chromium is dry-etched with using a chlorine-based gas, the etching must be performed for an etching-clear-time in which the light-shielding film composed of a material containing chromium disappears, added with an over-etching that is 100 to 300% of the etching-clear-time. This is because the chlorine-based dry etching is isotropic etching dominated by chemical components. Therefore, a desired pattern width is not stably formed since a pattern of the light-shielding film composed of a material containing chromium is insufficiently etched at the boundary with the phase shift film, resulting in a trailing shape.

Further, since the chlorine-based dry etching is isotropic etching dominated by chemical components, chlorine-based plasma moves in vertical and horizontal directions to the substrate, resulting in side etching in the pattern of the light-shielding film composed of a material containing chromium. Thus, to obtain uniform CD (Critical Dimension), which is a pattern line width, over the entire surface of the mask, it is necessary to obtain the same amount of side etching over the entire surface of the mask. For this purpose, long-time dry etching is required until the amount of side etching saturates and stabilizes.

On the other hand, in the case that the phase shift film composed of a material containing silicon is dry-etched with using a fluorine-based gas, the etching is performed for an etching-clear-time in which the phase shift film composed of a material containing silicon disappears, added with an over-etching that is up to 20% of the etching-clear-time (ex. short over-etching of 1 to 6 seconds). By the dry etching, the phase shift is adjusted to a phase shift of 175 to 185 degrees with respect to exposure light with slightly etching the transparent substrate in contact with the phase shift film. In this case, generally, the phase shift film composed of a material containing silicon is set to have an initial phase shift of 175 to 179 degrees, and the desired phase shift, i.e., 175 to 185 degrees is obtained by etching down into the transparent substrate by the over-etching.

Short-time over-etching is acceptable in fluorine-based dry etching because the fluorine-based dry etching is anisotropic etching dominated by physical components. Therefore, a trailing shape is not formed to the pattern of the phase shift film composed of a material containing silicon at the boundary with the substrate. Further, since fluorine-based plasma moves in vertical direction to the substrate surface, and the CD of the light-shielding film composed of a material containing chromium that functions as an etching mask is faithfully duplicated, thus, long-time over-etching is not necessary.

Fluorine-based dry etching is anisotropic etching dominated by physical components, thus, an amount of loss of the resist is generally larger than chlorine-based dry etching. Therefore, a resist film for forming a pattern of a hard mask film composed of a material containing silicon must be suitably thick. However, since a hard mask film composed of a material containing silicon acts as an etching mask when a light-shielding film composed of a material containing chromium is dry-etched with using a chlorine-based gas, and has etching resistance sufficiently to the chlorine-based gas, it is possible to thin the hard mask film composed of a material containing silicon. An etching time of the fluorine-based dry etching for the hard mask film is shortened when the hard mask film composed of a material containing silicon is thinned. As a result, the thickness of the resist film required for forming the pattern of the hard mask film composed of a material containing silicon can also be reduced. For this reason, by using a hard mask film composed a material containing silicon, it is possible to thin the thickness of the resist film used for etching of the hard mask film, i.e., the resist film first used for the phase shift mask blank. By thinning the resist film, the height-to-width ratio (aspect ratio) of the resist pattern is reduced. Therefore, in development process for forming a resist pattern, influence of impact of the developing solution or impact of pure water during rinsing process are reduced, a good assist pattern can be formed, and it is possible to realize high resolution of a transfer pattern.

A general method for manufacturing a phase shift mask from a phase shift mask blank in which a phase shift film composed of a material containing silicon, a light-shielding film composed of a material containing chromium, and a hard mask film composed of a material containing silicon are formed in this order on a transparent substrate by patterning the phase shift film is as follows. First, a resist film is formed on the hard mask film composed of a material containing silicon, and a resist pattern is formed by drawing a pattern onto the resist film by light or an electron beam, and developing. Next, the hard mask film composed of a material containing silicon is etched with using the resist pattern as an etching mask and a fluorine-based gas to form a pattern of the hard mask film, then, the resist film is removed. Next, the light-shielding film composed of a material containing chromium is etched with using the pattern of the hard mask film as an etching mask and a chlorine-based gas to form a pattern of the light-shielding film. Further, the phase shift film composed of a material containing silicon is etched with using the pattern of the light-shielding film as an etching mask and a fluorine-based gas to form a pattern of the phase shift film, and the pattern of the hard mask film is simultaneously removed. Then, the pattern of the light-shielding film is removed by etching using a chlorine-based gas.

Furthermore, it is becoming difficult to obtain further high pattern resolution, which has been demanded in projection exposure in recent years, even with a phase shift mask. Consequently, EUV lithography using, as exposure light, light in extreme ultraviolet range has been used.

Light in extreme ultraviolet range is easily absorbed by all materials, and transmission type lithography such as conventional photolithography using ArF excimer laser light cannot be used. Therefore, a reflective optical system is used in EUV lithography. A wavelength of light in extreme ultraviolet range used in EUV lithography is 13 to 14 nm, and the wavelength of conventional ArF excimer laser light is 193 nm. Thus, the wavelength of the light in extreme ultraviolet range is shorter compared with that of the conventional photolithography using ArF excimer laser light, and it is possible to transfer finer patterns formed in a photomask.

A photomask used in EUV lithography generally has a structure in which a reflection film that reflects light in extreme ultraviolet range, a protection film for protecting the reflection film, and a light-absorbing film that absorbs the light in extreme ultraviolet range are formed in this order on a substrate such as a glass substrate. As the reflection film, a multilayer reflection film in which low refractive index layers and high refractive index layers are alternately laminated that can enhance reflectance when light in the extreme ultraviolet range is irradiated to the surface of the reflection film is used. Generally, for the multilayer reflection film, a molybdenum (Mo) layer is used as the low refractive index layer and a silicon (Si) layer is used as the high refractive index layer. A ruthenium (Ru) film is usually used as the protection film. On the other hand, for the light-absorbing film, a material having a high absorption coefficient to EUV light, in particular, for example, a material containing chromium (Cr) or tantalum (Ta), as a main component, is used.

A general method for manufacturing a reflective photomask from a reflective photomask blank in which a reflection film that reflects light in extreme ultraviolet range, a protection film for protecting the reflection film, and a light-absorbing film that absorbs the light in extreme ultraviolet range are formed in this order on a substrate by patterning the light-absorbing film is as follows. First, a resist film is formed on the light-absorbing film, and a resist pattern is formed by drawing a pattern onto the resist film by light or an electron beam, and developing. Next, a pattern of the light-absorbing film is formed, then the resist pattern is removed.

In the reflective photomask required for EUV lithography, an assist pattern of a line pattern that assists resolution of a main pattern is further finer with minimalization of the main pattern, and it is required that a line width of the assist pattern is reduced to about 30 nm, particularly about 25 nm. Thus, a resist film used for the reflective photomask blank is required to be thinned compared with the phase shift mask blank.

In a reflective photomask, when an assist pattern of a line pattern having a thickness of about 30 nm, particularly about 25 nm is formed, it is required that a resist film has a thickness of not more than 80 nm. For example, when a pattern of a light-absorbing film (circuit pattern) is formed from the light-absorbing film containing tantalum as a main component by fluorine-based dry etching with using a resist pattern as an etching mask, fluorine-based dry etching is anisotropic etching dominated by physical components, and an etching rate of the resist pattern is relatively high. Thus, when the resist pattern is too thin, the resist pattern disappears during dry etching of the light-absorbing film, resulting in formation of pinhole defects in the light-absorbing film, and a normal reflective photomask cannot be manufactured.

To avoid the generation of the pinhole defects, the resist film is necessary to be formed thick. However, a thick resist film results in a higher aspect ratio of the resist pattern for forming a finer assist pattern. Thus, in the developing process for forming a resist pattern, the assist pattern collapses by impact of the developing solution or impact of pure water during rinsing process. As a result, desired resolution cannot be obtained.

For example, WO 2012/105508 A1 (Patent document 1) discloses a reflective mask blank for EUV lithography in which a layer that reflects EUV light, an absorbing layer that absorbs the EUV light, and a hard mask layer are formed in this order on a substrate. In this case, by the absorbing layer that is a layer in which at least one of tantalum (Ta) and palladium (Pd) is a main component, and the hard mask layer that contains chromium (Cr), nitrogen (N) or oxygen (O), and hydrogen (H), and has a total content of Cr and N or Cr and O of 85 to 99.9 at%, and a hydrogen content of 0.1 to 15 at%, the hard mask layer has a small surface roughness, sufficiently high etching selectivity in etching conditions of the absorbing layer, and amorphous state which can sufficiently reduce surface roughness.

As a result, a high-resolution pattern can be obtained without increasing line edge roughness of a pattern of the hard mask layer, further without increasing line edge roughness of a pattern of the absorbing layer formed with using the pattern of the hard mask layer.

In addition, WO 2012/105508 A1 (Patent Document 1) discloses a procedure for forming a pattern to a reflective mask blank for EUV lithography as follows. First, a resist film is formed on the hard mask layer of the EUV mask blank, and a pattern is formed in the resist film by an electron beam drawing device. Next, etching is performed to form a pattern of the hard mask layer by a chlorine-based gas process with using the patterned resist film as a mask. Next, etching is performed to form a pattern of the absorbing layer by a fluorine-based gas process with using the patterned hard mask layer as a mask. Next, etching is performed to remove the hard mask layer by a chlorine-based gas process.

### Citation List

Patent Document 1: WO 2012/105508 A1

### SUMMARY OF THE INVENTION

In the method described in WO 2012/105508 A1 (Patent Document 1), for example, a CrNH film or a CrOH film is used as a hard mask layer, and a film containing tantalum is used as an absorbing layer, and the absorbing layer is patterned by fluorine-based dry etching. In this case, the films (CrNH film and CrOH film) composed of a material containing chromium have high resistance to fluorine-based dry etching, thus, the films have a low etching rate, and the film containing tantalum as a main component has low resistance to fluorine-based dry etching, thus, the film has a high etching rate. Therefore, a resist film can be thinned. On the other hand, a film containing tantalum is patterned by chlorine-based dry etching, and an amount of loss of the resist film during dry etching decreases when the hard mask layer is thinned. Therefore, a resist film formed on the hard mask can be thinned. As a result, a height-to-width ratio (aspect ratio) of the resist pattern is reduced, and in development process for forming a resist pattern, influence of impact of the developing solution or impact of pure water during rinsing process is reduced. Therefore, a good assist pattern can be formed.

However, as described above, when a hard mask layer composed of a material containing chromium is dry-etched with using a chlorine-based gas, the etching must be performed for an etching-clear-time in which the hard mask layer composed of a material containing chromium disappears, added with an over-etching that is 100 to 300% of the etching-clear-time. In this case, the thickness of the resist film cannot be reduced to not more than 80 nm.

Another factor that hinders formation of a good assist pattern is a problem caused by a film composed of a material containing chromium. When a resist film is formed on a film composed of a material containing chromium, if particles are generated on the surface of or inside the resist film, and the resist film is used as it is, the particles cause defects in a phase shift mask or a reflective photomask. Therefore, generally, the resist film in which particles are generated is once removed by cleaning, and a resist is applied to form a resist film again.

A mixed solution of sulfuric acid and hydrogen peroxide solution (sulfuric acid-hydrogen peroxide mixture, SPM) is generally used for removing and cleaning the resist film. In this case, after the resist film is removed with using a mixed solution of sulfuric acid and hydrogen peroxide solution, the surface of the film composed ae material containing chromium is acidic. Thus, for neutralization, the surface is rinsed with using an alkaline solution added with ammonia (ammonia-peroxide water mixture (APM)). However, sulfuric acid usually corrodes the surface portion of a film composed of a material containing chromium. Therefore, generally, sulfuric acid cannot be completely removed from the surface portion of the film composed of a material containing chromium that has been corroded by sulfuric acid, and sulfate ions remain on the surface of the film composed of a material containing chromium. When sulfate ions remain on the surface of the film composed of a material containing chromium, the sulfate ions deteriorate adhesion between the film composed of a material containing chromium and the resist film that will be formed after. Therefore, in development process for forming a resist pattern, a resist pattern, particularly a line pattern such as an assist pattern is easy to collapse by impact of the developing solution or impact of pure water during rinsing process. As a result, a line pattern such as an assist pattern cannot be formed satisfactorily. Accordingly, it is required that the film in contact with the resist film has good adhesion to the resist film, and that the adhesion to the resist film does not deteriorate even when the film is contacted with a mixture solution of sulfuric acid and hydrogen peroxide solution.

In the above-described method described in WO 2012/105508 A1 (Patent Document 1), a pattern of a hard mask layer being a film composed of a material containing chromium is formed from a reflective mask blank for EUV lithography in which a layer that reflects EUV light, an absorbing layer that absorbs EUV light, and a hard mask layer are formed in this order on a substrate, and a resist film is formed on the hard mask layer when a pattern of the hard mask layer is formed. Thus, when the resist film is removed with using a mixed solution of sulfuric acid and hydrogen peroxide solution, adhesion between the hard mask layer and the resist film deteriorates also in this case.

The present invention has been made to solve the above problems. A first object of the present invention is to provide a reflective photomask blank having adhesion to a resist film formed again that is hard to be reduced even when a mixed solution of sulfuric acid and hydrogen peroxide solution is used for removing a resist film in manufacturing a reflective photomask from a reflective photomask blank in which a multilayer reflection film that reflects light in extreme ultraviolet range being exposure light, a protection film for protecting the multilayer reflection film, and a light-absorbing film that absorbs the exposure light are formed on a substrate. A second object of the present invention is to provide a reflective photomask blank that can satisfactorily form an assist pattern with a line width of about 30 nm, particularly about 25 nm, in particular, a reflective photomask blank that can satisfactorily form an assist pattern with a line width of about 30 nm, particularly about 25 nm even when a thin resist film, for example, a resist film having a thickness of not more than 80 nm is used. A third object of the present invention is to provide a method for manufacturing a reflective photomask from such a reflective photomask blank, and a reflective photomask manufactured from such a reflective photomask blank.

As described above, a conventional reflective photomask has a problem that the reflective photomask cannot be satisfactorily formed a fine assist pattern by a resist film having a thickness of not more than 80 nm since a resist film is not remained after dry etching, and has a problem that adhesion to the resist film deteriorates by a mixed solution of sulfate acid and hydrogen peroxide solution.

The inventors have been found, in a reflective photomask blank including a multilayer reflection film that reflects light in extreme ultraviolet range being exposure light, a protection film for protecting the multilayer reflection film, and a light-absorbing film that absorbs the exposure light formed on a substrate, that the problem can be solved by forming a hard mask film that functions as a hard mask in patterning a light-absorbing film by dry etching on and in contact with the light-absorbing film, and by forming the hard mask film constituted by a multilayer including a first layer disposed at the side remotest from the substrate and composed of a material containing silicon and free of chromium, and a second layer composed of a material containing chromium and free of silicon, particularly, by forming the first layer and the second layer having prescribed compositions and/or prescribed thicknesses.

In one aspect, the invention provides a reflective photomask blank including
a substrate,
a multilayer reflection film that is formed on the substrate and reflects exposure light being light in extreme ultraviolet range,
a protection film that is formed on the multilayer reflection film to protect the multilayer reflection film,
a light-absorbing film that is formed on the protection film and absorbs the exposure light, and
a hard mask film that is formed on and in contact with the light-absorbing film and functions as a hard mask in pattering the light-absorbing film by dry etching, wherein
   the hard mask film is constituted by a multilayer including a first layer and a second layer, the first layer is disposed at the side remotest from the substrate,
   the first layer is composed of a material containing silicon and free of chromium, and
   the second layer is composed of a material containing chromium and free of silicon.

Preferably, the material of the first layer further contains oxygen, and has a silicon content of not less than 25 at% and not more than 65 at%, and an oxygen content of not less than 30 at%.

Preferably, the first layer has a thickness of not less than 2 nm and not more than 12 nm.

Preferably, the material of the second layer further contains nitrogen, and has a chromium content of not less than 30 at% and not more than 90 at%, and a nitrogen content of not less than 8 at% and not more than 55 at%.

Preferably, the material of the second layer further contains oxygen, and has an oxygen content of not more than 40 at%.

Preferably, the material of the second layer further contains carbon, and has a carbon content of not more than 20 at%.

Preferably, the second layer has a thickness of not less than 2 nm and not more than 16 nm.

Preferably, the light-absorbing film is composed of a material containing tantalum.

Preferably, the light-absorbing film has a thickness of not less than 50 nm and not more than 74 nm.

Preferably, the reflective photomask blank includes a resist film that is formed on and in contact with the hard mask film and has a thickness of not more than 80 nm.

In another aspect, the invention provides a method for manufacturing a reflective photomask including a pattern of the light-absorbing film from the reflective photomask blank, wherein the method includes the steps of
(A) forming a resist film in contact with the hard mask film at the side remotest from the substrate,
(B) patterning the resist film to form a resist pattern,
(C) patterning the first layer to form a pattern of the first layer by dry etching using a fluorine-based gas with utilizing the resist pattern as an etching mask,
(D) removing the resist pattern,
(E) patterning the second layer to form a pattern of the second layer by dry etching using a chlorine-based gas with utilizing the pattern of the first layer as an etching mask,
(F) patterning the light-absorbing film to form a pattern of the light-absorbing film by dry etching using a fluorine-based gas with utilizing the pattern of the second layer as an etching mask, and simultaneously removing the pattern of the first layer, and
(G) removing the pattern of the second layer by dry etching using a chlorine-based gas.

Preferably, the resist film has a thickness of not more than 80 nm.

Preferably, the pattern of the light-absorbing film includes line patterns having a width of not more than 25 nm.

In another aspect, the invention provides a method for manufacturing a reflective photomask including a pattern of the light-absorbing film from the reflective photomask blank, wherein the method includes the steps of
(B) patterning the resist film to form a resist pattern,
(C) patterning the first layer to form a pattern of the first layer by dry etching using a fluorine-based gas with utilizing the resist pattern as an etching mask,
(D) removing the resist pattern,
(E) patterning the second layer to form a pattern of the second layer by dry etching using a chlorine-based gas with utilizing the pattern of the first layer as an etching mask,
(F) patterning the light-absorbing film to form a pattern of the light-absorbing film by dry etching using a fluorine-based gas with utilizing the pattern of the second layer as an etching mask, and simultaneously removing the pattern of the first layer, and
(G) removing the pattern of the second layer by dry etching using a chlorine-based gas.

Preferably, the resist film has a thickness of not more than 80 nm.

Preferably, the pattern of the light-absorbing film includes line patterns having a width of not more than 25 nm.

In the other aspect, the invention provides a reflective photomask including
a substrate,
a multilayer reflection film that is formed on the substrate and reflects exposure light being light in extreme ultraviolet range,
a protection film that is formed on the multilayer reflection film to protect the multilayer reflection film, and
a pattern of a light-absorbing film that is formed on the protection film and absorbs the exposure light, wherein
   the pattern of the light-absorbing film includes line patterns having a width of not more than 25 nm.

### ADVANTAGEOUS EFFECTS

According to the present invention, since adhesion of a resist film formed again is hard to be reduced even when a mixed solution of sulfuric acid and hydrogen peroxide solution is used for removing a resist film, a resist pattern to form a fine assist pattern is hard to collapse by impact of a developing solution or impact of pure water during rinsing process in developing process for forming a resist pattern. Further, according to the present invention, a resist film is thinned, and an assist pattern with a line width of about 30 nm, particularly about 25 nm can be satisfactorily formed by a resist pattern having a lowered height-to-width ratio (aspect ratio). Therefore, high resolution can be obtained in a transfer pattern of a reflective photomask manufactured from a reflective photomask blank.

### BRIEF DESCRIPTION OF THE DRAWINGS

FIG. 1 is a cross-sectional view illustrating an example of first embodiment of the inventive reflective photomask blank.
FIG. 2 is a cross-sectional view illustrating an example of second embodiment of the inventive reflective photomask blank.
FIG. 3 is a cross-sectional view illustrating an example of the inventive reflective photomask.
FIGS. 4A to 4G are cross-sectional views for explaining steps of manufacturing the reflective photomask from the inventive reflective photomask blank in the invention.

### FURTHER EXPLANATIONS; OPTIONS AND PREFERENCES

A reflective photomask blank of first embodiment of the invention includes a substrate, a multilayer reflection film that is formed on the substrate and reflects exposure light being light in extreme ultraviolet range, a protection film for protecting the multilayer reflection film that is formed on the multilayer reflection film, a light-absorbing film that is formed on the protection film and absorbs the exposure light being light in extreme ultraviolet range, and a hard mask film that is formed on and in contact with the light-absorbing film and functions as a hard mask in pattering the light-absorbing film by dry etching. The hard mask film is a film (laminated film) that is constituted by a multilayer including a first layer disposed at the side remotest from the substrate, and a second layer.

A reflective photomask blank of the invention may further include a resist film. A reflective photomask blank of the second embodiment of the invention includes a substrate, a multilayer reflection film that is formed on the substrate and reflects exposure light being light in extreme ultraviolet range, a protection film for protecting the multilayer reflection film that is formed on the multilayer reflection film, a light-absorbing film that is formed on the protection film and absorbs the exposure light being light in extreme ultraviolet range, a hard mask film that is formed on and in contact with the light-absorbing film and functions as a hard mask in pattering the light-absorbing film by dry etching, and a resist film that is formed on and in contact with the hard mask film. The hard mask film is a film (laminated film) that is constituted by a multilayer including a first layer disposed at the side remotest from the substrate, and a second layer.

From the reflective photomask blanks of the first and second embodiments, a reflective photomask including, for example, a substrate, a multilayer reflection film that is formed on the substrate and reflects exposure light being light in extreme ultraviolet range, a protection film for protecting the multilayer reflection film that is formed on the multilayer reflection film, and a pattern (circuit pattern or photomask pattern) of the light-absorbing film that is formed on the protection film and absorbs the exposure light being light in extreme ultraviolet range can be obtained.

The structures of the reflective photomask blank and the reflective photomask of the invention are described below with reference to the drawings. In the description of the drawings, the same constituent elements may be denoted by the same reference numerals, and the description thereof may be omitted. In addition, the drawings may be expanded for the sake of convenience, and the dimensional ratio of each component is not necessarily the same as the actual one.

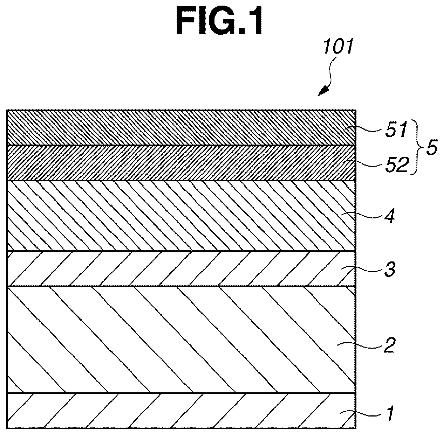

FIG. 1 is a cross-sectional view illustrating an example of first embodiment of the inventive reflective photomask blank. This reflective photomask blank 101 includes a substrate 1, a multilayer reflection film 2 that is formed on and in contact with the substrate 1 and reflects exposure light being light in extreme ultraviolet range, a protection film 3 for protecting the multilayer reflection film 2 that is formed on and in contact with the multilayer reflection film 2, a light-absorbing film 4 that is formed on and in contact with the protection film 3 and absorbs the exposure light, and a hard mask film 5 that is formed on and in contact with the light-absorbing film 4 and functions as a hard mask in pattering the light-absorbing film 4 by dry etching. In this case, the hard mask film 5 is constituted by two layers consisting of a first layer 51 disposed at the side remotest from the substrate 1, and a second layer 52 disposed at the side close to the substrate 1. In other words, the multilayer reflection film 2, the protection film 3, the light-absorbing film 4, the second layer 52 of the hard mask film 5, and the first layer 51 of the hard mask film 5 are laminated in this order from the side of the substrate 1 in this reflective photomask blank 101.

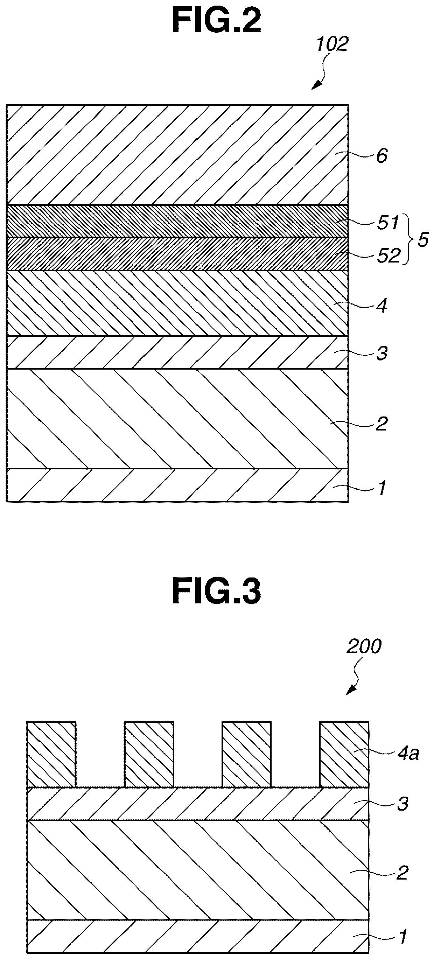

FIG. 2 is a cross-sectional view illustrating an example of second embodiment of the inventive reflective photomask blank. This reflective photomask blank 102 includes a substrate 1, a multilayer reflection film 2 that is formed on and in contact with the substrate 1 and reflects exposure light being light in extreme ultraviolet range, a protection film 3 for protecting the multilayer reflection film 2 that is formed on and in contact with the multilayer reflection film 2, a light-absorbing film 4 that is formed on and in contact with the protection film 3 and absorbs the exposure light, a hard mask film 5 that is formed on and in contact with the light-absorbing film 4 and functions as a hard mask in pattering the light-absorbing film 4 by dry etching, and a resist film 6 that is formed on and in contact with the hard mask film 5. In this case, the hard mask film 5 is constituted by two layers consisting of a first layer 51 disposed at the side remotest from the substrate 1, and a second layer 52 disposed at the side close to the substrate 1. In other words, the multilayer reflection film 2, the protection film 3, the light-absorbing film 4, the second layer 52 of the hard mask film 5, the first layer 51 of the hard mask film 5, and the resist film 6 are laminated in this order from the side of the substrate 1 in this reflective photomask blank 102.

FIG. 3 is a cross-sectional view illustrating an example of the inventive reflective photomask 200. This reflective photomask 200 includes a substrate 1, a multilayer reflection film 2 that is formed on and in contact with the substrate 1 and reflects exposure light being light in extreme ultraviolet range, a protection film 3 for protecting the multilayer reflection film 2 that is formed on and in contact with the multilayer reflection film 2, and a pattern (circuit pattern or photomask pattern) of a light-absorbing film 4a that is formed on and in contact with the protection film 3 and absorbs the exposure light. In other words, the multilayer reflection film 2, the protection film 3, the pattern of the light-absorbing film 4a are laminated in this order from the side of the substrate 1 in this reflective photomask 200.

### [Substrate]

Type or size of the substrate is not particularly limited, and the substrate for the reflective photomask blank and the reflective photomask may be transparent or no transparent with respect to the exposure wavelength. As the substrate, for example, a glass substrate such as a quartz substrate may be used. Further, a suitable substrate is a substrate called a 6025 substrate having a size of 6 inches square and a thickness of 0.25 inches, which is defined in the SEMI standard. The 6025 substrate is generally represented a substrate having 152 mm square and 6.35 mm thick in the SI unit system.

### [Multilayer Reflection Film]

The multilayer reflection film is a film that reflects exposure light being light in extreme ultraviolet range. The multilayer reflection film is preferably formed in contact with the substrate. This light in extreme ultraviolet range is called EUV light, and has a wavelength of 13 to 14 nm. The EUV light is usually light having a wavelength of about 13.5 nm. A material constituting the multilayer reflection film is preferably resistant to dry etching (chlorine-based dry etching) using a chlorine-based gas (for example, only Cl₂ gas or a mixed gas of Cl₂ gas and O₂ gas), and is preferably removable by dry etching (fluorine-based dry etching) using a fluorine-based gas (for example, CF₄ gas or SF₆ gas). In particular, examples of the material constituting the multilayer reflection film include molybdenum (Mo) and silicon (Si). As the multilayer reflection film, a laminated film (Si/Mo laminated film) in which about 20 to 60 layers of molybdenum (Mo) layers and silicon (Si) layers are alternately laminated is generally used. The multilayer reflection film has a thickness of preferably not less than 200 nm, more preferably not less than 220 nm, and preferably not more than 340 nm, more preferably not more than 280 nm.

### [Protection Film]

The protection film is a film for protecting the multilayer reflection film. The protection film is preferably formed in contact with the multilayer reflection film. The protection film is provided to protect the multilayer reflection film, for example, in cleaning in processing to a reflective photomask, and in correction of the reflective photomask. Further, it is preferable that the protection film has a function for protecting the multilayer reflection film in patterning the light-absorbing film by etching, or a function for preventing oxidation of the multilayer reflection film. A material constituting the protection film preferably has etching characteristics different from those of the light-absorbing film, in particular, the material is preferably resistant to chlorine-based dry etching. Examples of the material constituting the protection film include a material containing ruthenium (Ru). The protection film may be a single layer film, or a multilayer film (for example, a film consisting of 2 to 4 layers), and may be a film having a compositional gradient. The protection film has a thickness of preferably not less than 1 nm, and preferably not more than 20 nm.

### [Light-absorbing Film]

The light-absorbing film is a film that absorbs exposure light being light in extreme ultraviolet range. The light-absorbing film is preferably formed in contact with the protection film. The light-absorbing film is preferably composed of a material that is resistant to chlorine-based dry etching, and removable by fluorine-based dry etching. The light-absorbing film is preferably composed of a material containing tantalum (Ta). Examples of the material containing tantalum include a simple tantalum (Ta), a tantalum compound containing tantalum (Ta), and at least one element selected from the group consisting of oxygen (O), nitrogen (N) and boron (B). In particular, the examples include a material consisting of tantalum (Ta), a material consisting of tantalum and oxygen (TaO), a material consisting of tantalum and nitrogen (TaN), a material consisting of tantalum and boron (TaB), a material consisting of tantalum, oxygen and nitrogen (TaON), a material consisting of tantalum, oxygen and boron (TaOB), a material consisting of tantalum, nitrogen and boron (TaNB), and a material consisting of tantalum, oxygen, nitrogen and boron (TaONB). The light-absorbing film may be a single layer film, or a multilayer film (for example, a film consisting of 2 to 4 layers), and may be a film having a compositional gradient. The light-absorbing film has a thickness of preferably not less than 30 nm, more preferably not less than 40 nm, even more preferably not less than 50 nm, and preferably not more than 100 nm, more preferably not more than 80 nm, even more preferably not more than 74 nm.

### [Hard Mask Film]

The hard mask film of the invention is constituted by a multilayer including a first layer disposed at the side remotest from the substrate, and a second layer disposed at a portion other than the portion at the side remotest from the substrate. The hard mask film is not limited to a film consisting of two layers, and may consist of three or more layers. For example, the hard mask film may consist of three layers, four layers or five layers. The second layer is preferable disposed at the side closest to the substrate.

The first layer of the hard mask film is composed of a material containing silicon (Si) and free of chromium (Cr). The first layer is composed of a material that is resistant to chlorine-based dry etching, and removable by fluorine-based dry etching. The first layer functions as an etching mask in etching of the second layer by such etching characteristics.

The second layer of the hard mask film is composed of a material containing chromium (Cr) and free of silicon (Si). The second layer is composed of a material that is resistant to fluorine-based dry etching, and removable by chlorine-based dry etching. The second layer functions as an etching mask in etching of the light-absorbing film by such etching characteristics. In addition, other layer constituting the hard mask other than the first and second layers is preferably composed of a material containing chromium (Cr) and free of silicon (Si). Constituent elements of the other layer may be the same or different constituent elements. When the constituent elements of the other layer are the same, the other layer is preferably a layer having a different ratio of the constituent elements. However, ratio of the constituent elements may be the same, when the other layer is not contacted with the second layer.

### [First Layer of Hard Mask Film]

A material of the first layer is a material containing silicon and free of chromium. The first layer in the first embodiment is a layer that will be contacted with the resist film, and the first layer in the second embodiment) is a layer that is contacted with the resist film. The first layer is a layer that will be contacted with a mixed solution of sulfuric acid and hydrogen peroxide solution (sulfuric acid-hydrogen peroxide mixture: SPM), or a solution added with ammonia (ammonia-peroxide water mixture (APM)) in removing the resist film and cleaning. Further, the first layer is a layer that functions as an etching mask (a hard mask) in etching of the second layer.

The material of the first layer may contain at least one element selected from the group consisting of oxygen (O), nitrogen (N) and carbon (C), other than silicon. Particularly, the material preferably consists of silicon, and at least one element selected from the group consisting of oxygen, nitrogen and carbon. When the material of the first layer contains an element other than silicon, the material has a silicon content of less than 100 at%, and has a silicon content of preferably not more than 65 at%, more preferably not more than 60 at%. When the silicon content is lower, an etching rate of the first layer is higher in fluorine-based dry etching. On the other hand, the silicon content has a lower limit of normally not less than 25 at%, preferably not less than 30 at%.

The material of the first layer preferably contains oxygen. Particularly, a preferable material is silicon oxide (SiO) which consists of silicon and oxygen. When the material of the first layer contains oxygen, the material has a silicon content of preferably not less than 25 at%, more preferably not less than 30 at%, and preferably not more than 65 at%, more preferably not more than 60 at%. On the other hand, the material has an oxygen content of preferably not less than 30 at%, more preferably not less than 38 at%, and preferably not more than 70 at%, more preferably not more than 68 at%.

The first layer is patterned by fluorine-based dry etching with using, as an etching mask, a resist pattern that is formed in contact with the first layer. When the first layer is thin, the etching time is shortened, thus, the first layer has a thickness of not more than 16 nm, more preferably not more than 12 nm, even more preferably not more than 10 nm.

On the other hand, if the first layer is too thin, the function as an etching mask in etching of the second layer is lost, and sensitivity in defect inspection of the hard mask film is decreased. Thus, the first layer has a thickness of preferably not less than 2 nm, more preferably not less than 4 nm.

The material containing silicon and free of chromium is resistant to chlorine-based dry etching of the second layer, thus, a pattern of the first layer functions as an etching mask in etching of the second layer. Further, the thickness of the resist film used for etching of the first layer can be thinned, because the first layer can be etched by fluorine-based dry etching which does not require over-etching for a long time. Particularly, a material containing oxygen with silicon and free of chromium, preferably, the material containing each of the elements at the above-described content, more preferably, the material containing oxygen at a comparably high content has a high adhesion to the resist film. Further, compared to a material containing chromium, the material is hard to be dissolved into a mixed solution of sulfuric acid and hydrogen peroxide solution and a solution added with ammonia, and it is possible to stably maintain optical characteristics necessary for defect inspection. Particularly, compared to a material containing chromium, the material is hard to be corroded by sulfuric acid, thus, the adhesion to the resist film is hard to deteriorate in contacting to the mixed solution of sulfuric acid and hydrogen peroxide solution. For these reasons, by forming such a first layer at the side remotest from the substrate in the etching mask film, in development process for forming a resist pattern, the resist pattern is hard to collapse by impact of the developing solution or impact of pure water during rinsing process even when the resist pattern is a fine line pattern such as an assist pattern. Therefore, a good assist pattern can be formed and high resolution can be obtained.

In addition, the material of the first layer is a material that is removable by fluorine-based dry etching, thus, the pattern of the first layer can be simultaneously removed in forming a pattern of the light-absorbing film by fluorine-based dry etching for forming the pattern of the light-absorbing film.

### [Second Layer of Hard Mask Film]

A material of the second layer is a material containing chromium and free of silicon. The second layer is a layer that functions as an etching mask (a hard mask) in etching of the light-absorbing film.

The material of the second layer may contain as at least one element selected from the group consisting of oxygen (O), nitrogen (N) and carbon (C), other than chromium. Particularly, the material preferably consists of chromium, and at least one element selected from the group consisting of oxygen, nitrogen and carbon. When the material of the second layer contains an element other than chromium, the material has a chromium content of less than 100 at%, and has a chromium content of preferably not more than 90 at%, more preferably not more than 88 at%. When the chromium content is lower, an etching rate of the second layer is higher in chlorine-based dry etching. On the other hand, the silicon content has a lower limit of normally not less than 30 at%, preferably not less than 31 at%.

The material of the second layer preferably contains nitrogen. Particularly, a preferable material is chromium nitride (CrN) which consists of chromium and nitrogen. When the material of the second layer contains nitrogen, the material has a chromium content of preferably not less than 30 at%, more preferably not less than 31 at%, and preferably not more than 90 at%, more preferably not more than 88 at%. On the other hand, the material has a nitrogen content of preferably not less than 8 at%, more preferably not less than 10 at%, and preferably not more than 55 at%, more preferably not more than 52 at%.

The material of the second layer preferably contains oxygen with nitrogen. Particularly, a preferable material is chromium oxynitride (CrON) which consists of chromium, oxygen and nitrogen. When the material of the second layer contains oxygen, the material has an oxygen content of preferably not more than 40 at%, more preferably not more than 38 at%. Further, the oxygen content may have a lower limit of preferably not less than 2 at%, more preferably not less than 20 at%, however, not particularly limited thereto. When the material of the second layer contains oxygen, the material of the second layer may have a chromium content and a nitrogen content in the ranges described above.

Furthermore, the material of the second layer preferably contains carbon with nitrogen and oxygen. Particularly, a preferable material is chromium nitride oxide carbide (CrNOC) which consists of chromium, nitrogen, oxygen and carbon. When the material of the second layer contains carbon, the material has a carbon content of preferably not more than 20 at%, more preferably not more than 15 at%. Further, the carbon content may have a lower limit of preferably not less than 2 at%, more preferably not less than 5 at%, however, not particularly limited thereto. When the material of the second layer contains carbon, the material of the second layer may have a chromium content, a nitrogen content and an oxygen content in the ranges described above.

The second layer is patterned by chlorine-based dry etching with using, as an etching mask, the pattern of the first layer that is formed in contact with the second layer. The first layer is also exposed to chlorine-based dry etching and is gradually thinned. If the first layer disappears, pinhole defects are formed in the second layer. As a result, when the light-absorbing film is dry-etched with using, as an etching mask, a pattern of the second layer, plasma of etching of the light-absorbing film reaches to the light-absorbing film through the pinhole defects, causing pinhole defects in the light-absorbing film. Therefore, the thin second layer is preferable that can shorten the etching time, and the second layer has a thickness of preferably not more than 16 nm, more preferably not more than 10 nm. On the other hand, if the second layer is too thin, the function as an etching mask in etching of the light-absorbing film is lost, and sensitivity in defect inspection of the hard mask film is decreased. Thus, the second layer has a thickness of preferably not less than 2 nm, more preferably not less than 4 nm.

The material containing chromium and free of silicon is resistant to fluorine-based dry etching for the light-absorbing film, thus, a pattern of the second layer functions as an etching mask in etching of the light-absorbing film. Particularly, a material containing nitrogen, nitrogen and oxygen, or nitrogen, oxygen and carbon, with chromium, and free of silicon, preferably, the material containing each of the elements at the above-described content, more preferably, the material containing nitrogen at comparably high content, or the material containing nitrogen and oxygen at comparably high contents has a high etching rate, resulting in a short etching time. For this reason, by forming the second layer with the first layer, high resolution can be obtained.

In addition, the material of the second layer is a material that is removable by chlorine-based dry etching, thus, as long as the light-absorbing film is composed of a material that is resistant to chlorine-based dry etching, after forming a pattern of the light-absorbing film, the pattern of the second layer can be removed by chlorine -based dry etching with remaining the pattern of the light-absorbing film.

### [Resist Film]

The resist film may be an electron beam resist that is drawn with an electron beam or a photoresist that is drawn with light, and a chemically amplified resist is preferable. The chemically amplified resist may be a positive type or a negative type. Examples of the resist include a resist containing a base resin such as a hydroxystyrene-based resin or a (meth)acrylic acid-based resin, and an acid generator, and optionally containing a crosslinking agent, a quencher, a surfactant, or other components.

Since the first layer is disposed at the side remotest from the substrate in the etching mask film of the invention, the resist film in contact with this first layer may be thinned, as described above. In view of forming the resist pattern for forming a fine assist pattern that is hard to collapse by impact of the developing solution or impact of pure water during rinsing process, in development process for forming the resist pattern, the resist film preferably has a thickness of not more than 100 nm. Further, in view of forming satisfactorily a line pattern such as an assist pattern having a width of about 30 nm, particularly about 25 nm, the thickness is more preferably not more than 80 nm, even more preferably not more than 60 nm. The resist film preferably has at least a thickness at which the resist film functions as an etching mask in etching of the first layer and the resist pattern will remain on the entire pattern of the first layer after etching. The resist film preferably has a thickness of not less than 30 nm, more preferably not less than 40 nm, however, not particularly limited thereto.

In the invention, the multilayer reflection film, the protection film, the light-absorbing film, and the hard mask film including the first layer and the second layer are preferably formed by a sputtering method that has good controllability and can be easy to form a film having predetermined characteristics, however, not particularly limited thereto. As the sputtering method, DC sputtering, RF sputtering can be applied, however, not particularly limited thereto.

When a laminated film of molybdenum layers and silicon layers, as the multilayer reflection film, is formed, a molybdenum target and a silicon target can be used as sputtering targets. When a film composed of a material containing ruthenium, as the protection film, a ruthenium target can be used as a sputtering target. When a film composed of a material containing tantalum, as the light-absorbing film, a tantalum target can be used as a sputtering target. As the hard mask film, when the first layer composed of a material containing silicon and free of chromium, and the second layer composed of a material containing chromium and free of silicon, a silicon target and a chromium target can be used as sputtering targets, respectively.

A power to be supplied to the sputtering target may be appropriately set depending on the size of the sputtering target, cooling efficiency, controllability of film formation. The power is normally 50 to 3000 W/cm² as a power per area of the sputtering surface of the sputtering target. As a sputtering gas, a rare gas such as helium gas (He gas), neon gas (Ne gas) and argon gas (Ar gas) may be used. When each film or each layer included in the film that contains only the element constituting the target is formed, the film or the layer can be formed with using only the rare gas as the sputter gas.

When each of the films or each of the layers included in the film is formed by a material containing oxygen, nitrogen or carbon, the sputtering is preferably reactive sputtering. A rare gas such as helium gas (He gas), neon gas (Ne gas) and argon gas (Ar gas), and a reactive gas are used as sputtering gases for the reactive sputtering. For example, oxygen gas (O₂ gas) may be used as the reactive gas for forming a film composed of a material containing oxygen, and nitrogen gas (N₂ gas) may be used as the reactive gas for forming a film composed of a material containing nitrogen. A reactive gas appropriately selected from oxygen gas (O₂ gas), nitrogen gas (N₂ gas), and nitrogen oxide gas such as nitrogen monoxide gas (NO gas), nitrogen dioxide gas (NO₂ gas) and nitrous oxide gas (N₂O gas) may be used as the reactive gas for forming a film composed of a material containing both nitrogen and oxygen. Methane gas (CH₄ gas) or a gas containing carbon such as carbon monoxide gas (CO gas) and carbon dioxide gas (CO₂) may be used as the reactive gas for forming a film composed of a material containing carbon. Oxygen gas (O₂ gas), nitrogen gas (N₂ gas) and carbon dioxide gas (CO₂) may be simultaneously used as the reactive gas for forming a film composed of a material containing oxygen, nitrogen and carbon.

A pressure in forming each of the films and each of the layers included in the film may be appropriately set in consideration of film stress, chemical resistance, cleaning resistance. Normally, chemical resistance is improved by setting the pressure at not less than 0.01 Pa, particularly not less than 0.03 Pa, and not more than 1 Pa, particularly not more than 0.3 Pa. Further, a flow rate of each gas may be appropriately set so as to obtain a desired composition, and is normally 0.1 to 100 sccm.

In manufacturing process of the reflective photomask blank, the substrate or the substrate and the film formed on the substrate may be heat-treated before forming the resist film. As a heat treatment method, an infrared heating, a resistance heating or others can be applied, and conditions of the treatment are not particularly limited. The heat treatment may be performed, for example, under atmosphere of a gas containing oxygen. A concentration of the gas containing oxygen is, for example, 1 to 100 vol% in the case of oxygen gas (O₂ gas), however not particularly limited thereto. A temperature of the heat treatment is preferably not less than 200 °C, more preferably not less than 400 °C.

In manufacturing process of the reflective photomask blank, before forming the resist film, the film formed on the substrate, particularly the hard mask film may be subjected to ozone treatment, plasma treatment, and conditions of the treatment are not particularly limited. Each of the treatments may be carried out to increase oxygen concentration on the surface portion of the film. In this case, the conditions of the treatment may be appropriately adjusted so as to obtain a predetermined oxygen concentration. In addition, when the film is formed by sputtering, the oxygen concentration in the surface portion of the film can be increased also by adjusting a ratio of the rare gas and the gas containing oxygen (oxidizing gas) such as oxygen gas (O₂ gas), carbon monoxide gas (CO gas), and carbon dioxide gas (CO₂ gas) in the sputtering gas.

Further, in manufacturing process of the reflective photomask blank, before forming the resist film, a cleaning treatment may be performed to remove defects which present on the surface of the substrate or the film formed on the substrate. The cleaning can be performed with using either or both of ultrapure water and a functional water, which is ultrapure water containing ozone gas, hydrogen gas, or others. Further, the cleaning may be performed by ultrapure water containing a surfactant, followed by cleaning with either or both of ultrapure water and the functional water. The cleaning may be performed while irradiating with ultrasonic wave, if necessary, and may also be combined with UV light irradiation.

A method of forming the resist film (applying the resist) is not particularly limited, and a known method may be applied.

Next, a method for manufacturing a reflective photomask from the reflective photomask blank of the invention will be described with reference to the drawings. When a reflective photomask is manufactured from the reflective photomask blank of the invention, a method including forming of a resist pattern from the resist film, forming a pattern of the underlying film or layer by dry etching using a fluorine-based gas (fluorine-based dry etching) or dry etching using a chlorine-based gas (chlorine-based dry etching) that is selected in accordance with the material forming the film or layer, and removing the resist pattern may be applied. Further, in manufacturing the reflective photomask, the resist film and the resist pattern can be removed by a sulfuric acid-hydrogen peroxide mixture.

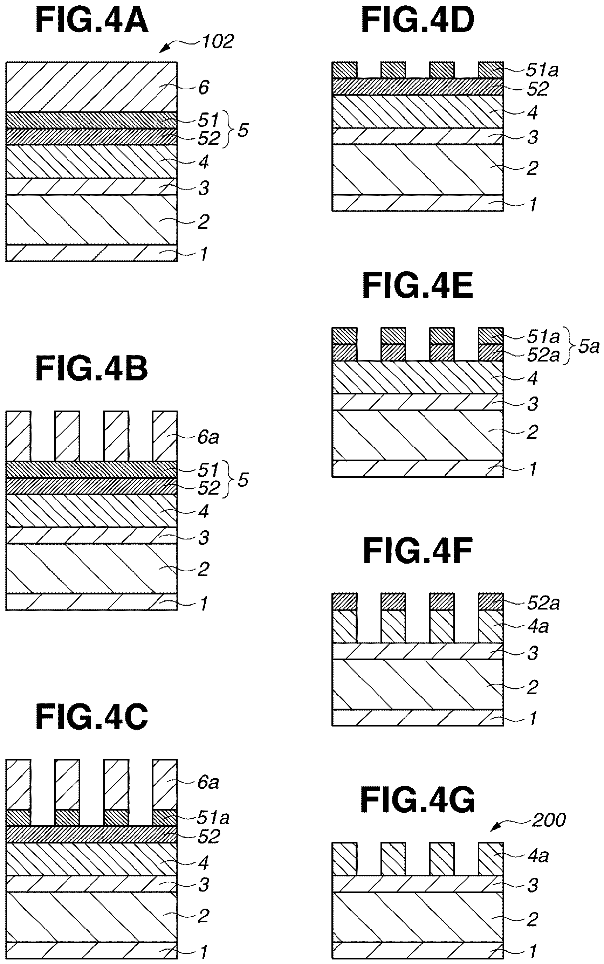

FIGS. 4A to 4G are cross-sectional views for explaining steps of manufacturing the reflective photomask from the inventive reflective photomask blank in the invention.

First, as described in FIG. 4A, a resist film 6 is formed in contact with the side remote from a substrate 1 of a hard mask film 5, i.e., in contact with a first layer 51, to a reflective photomask blank 101 of the first embodiment (Step (A)). Here, the resist film 6 may be inspected, and if the resist film 6 has defects such as particles, the resist film 6 may be removed once and the resist film 6 may be formed again.

Next, as described in FIG. 4B, the resist film 6 is patterned to form a resist pattern 6a (Step (B)).

Next, as described in FIG. 4C, the first layer 51 is patterned by dry etching using a fluorine-based gas with using the resist pattern 6a as an etching mask to form a pattern of the first layer 51a (Step (C)).

Next, as described in FIG. 4D, the resist pattern 6a is removed (Step (D)).

Next, as described in FIG. 4E, a second layer 52 is patterned by dry etching using a chlorine-based gas with using the pattern of the first layer 51a as an etching mask to form a pattern of the second layer 52a (Step (E)). As a result, a pattern of the hard mask film 5a including the pattern of the first layer 51a and the pattern of the second layer 52a is formed.

Next, as described in FIG. 4F, a light-absorbing film 4 is patterned by dry etching using a fluorine-based gas with using the pattern of the second layer 52a as an etching mask to form a pattern of the light-absorbing film 4a, and the pattern of the first layer 51a is simultaneously removed (Step (F)). Here, the pattern of the first layer 51a composed of a material containing silicon and free of chromium is removed by the fluorine-based dry etching. On the other hand, the pattern of the second layer 52a composed of a material containing chromium and free of silicon is resistant to the fluorine-based dry etching, thus, functions as an etching mask and remains on the pattern of the light-absorbing film 4a after the dry etching.

Next, as described in FIG. 4G, the pattern of the second layer 52a is removed by dry etching using chlorine-based gas (Step (G)).

In the case of manufacturing a reflective photomask from a reflective photomask blank of the second embodiment, Step (A) may be omitted since a resist film has been already formed, thus, Step (B) to Step (G) may be conducted. Further, prior to Step (B) to Step (G), the resist film 6 may be inspected, and if the resist film 6 has defects such as particles, the resist film 6 may be removed once and the resist film 6 may be formed again.

According to the method, by forming a thin resist film having a thickness of, for example, not more than 80 nm to a reflective photomask blank, or from a reflective photomask blank in which a thin resist film having a thickness of, for example, not more than 80 nm has been formed, even when the line pattern has a line width of not more than 30 nm (30 nm or less), particularly not more than 25 nm (25nm or less), a reflective photomask in which a pattern of a light-absorbing film having a good line pattern such as an assist pattern has been formed can be obtained by patterning the light-absorbing film.

In the invention, the line pattern such as an assist pattern formed in the pattern of the light-absorbing film of the reflective photomask has a lower limit of the width of normally not less than 10 nm.

### EXAMPLES

Examples of the invention are given below by way of illustration and not by way of limitation.

### Example 1

A reflective photomask blank (a reflective photomask blank of the first embodiment), as shown in FIG. 1, was manufactured by laminating a multilayer reflection film, a protection film, a light-absorber film, and a hard mask film consisting of a first layer and a second layer in the order on a quartz substrate having dimensions of 152 mm square and 6.35 mm thick.

First, the multilayer reflection film that is a laminated film (thickness: 280 nm) in which molybdenum (Mo) layers and silicon (Si) layers are alternately laminated and has a reflectance of 67% with respect to light having a wavelength of 13.5 nm was formed on the quartz substrate with using a molybdenum target and a silicon target as targets, and argon gas as a sputtering gas, by sputtering the molybdenum target and the silicon target, alternately, with adjusting applied powers to the targets and a flow rate of the sputtering gas.

Next, a ruthenium (Ru) film (thickness: 4 nm) as the protection film composed of a material containing ruthenium was formed on the multilayer reflection film with using a ruthenium target as a target, and argon gas as a sputtering gas, by sputtering the ruthenium target with adjusting an applied power to the target and a flow rate of the sputtering gas.

Next, a tantalum nitride (TaN) film (thickness: 64 nm) as the light-absorbing film composed of a material containing tantalum was formed on the protection film with using a tantalum target as a target, and argon gas and nitrogen gas as sputtering gases, by sputtering the tantalum target with adjusting an applied power to the target and flow rates of the sputtering gases.

Next, a chromium nitride oxide (CrNO) layer as the second layer composed of a material containing chromium and free of silicon of the hard mask film was formed on the light-absorbing film with using a chromium target as a target, and argon gas, nitrogen gas and oxygen gas as sputtering gases, by sputtering the chromium target with adjusting an applied power to the target and flow rates of the sputtering gases.

Further, a silicon oxide (SiO) layer as the first layer composed of a material containing silicon and free of chromium of the hard mask film was formed on the second layer with using a silicon target as a target, and argon gas and oxygen gas as sputtering gases, by sputtering the silicon target with adjusting an applied power to the target and flow rates of the sputtering gases. As a result, the reflective photomask blank was obtained. Compositions of the first layer and the second layer, and thicknesses of the first layer and the second layer are shown in Table 1. The composition was measured by an X-ray photoelectron spectrometer, and the thickness was measured by an X-ray diffractometer (the same in the following measurements).

### Example 2

A reflective photomask blank was obtained by the same manner in Example 1, except that the ratio of silicon and oxygen in the first layer was changed. Compositions of the first layer and the second layer, and thicknesses of the first layer and the second layer are shown in Table 1.

### Example 3

A reflective photomask blank was obtained by the same manner in Example 1, except that the thicknesses of the first layer and the second layer were changed. Compositions of the first layer and the second layer, and thicknesses of the first layer and the second layer are shown in Table 1.

### Example 4

A reflective photomask blank was obtained by the same manner in Example 3, except for the formation of the second layer was changed to the following manner. A chromium nitride (CrN) layer as the second layer was formed with using a chromium target as a target, and argon gas and nitrogen gas as sputtering gases, by sputtering the chromium target with adjusting an applied power to the target and flow rates of the sputtering gases. Compositions of the first layer and the second layer, and thicknesses of the first layer and the second layer are shown in Table 1.

### Example 5

A reflective photomask blank was obtained by the same manner in Example 1, except that the thickness of the first layer and the ratio of chromium, nitrogen and oxygen in the second layer were changed. Compositions of the first layer and the second layer, and thicknesses of the first layer and the second layer are shown in Table 1.

### Example 6

A reflective photomask blank was obtained by the same manner in Example 2, except that the thicknesses of the first layer and the second layer were changed. Compositions of the first layer and the second layer, and thicknesses of the first layer and the second layer are shown in Table 1.

### Example 7

A reflective photomask blank was obtained by the same manner in Example 5, except for the formation of the second layer was changed to the following manner. A chromium nitride oxide carbide (CrNOC) layer as the second layer was formed with using a chromium target as a target, and argon gas, nitrogen gas and carbon dioxide gas as sputtering gases, by sputtering the chromium target with adjusting an applied power to the target and flow rates of the sputtering gases. Compositions of the first layer and the second layer, and thicknesses of the first layer and the second layer are shown in Table 1.

### Example 8

A reflective photomask blank was obtained by the same manner in Example 1, except that the thickness of the first layer was changed. Compositions of the first layer and the second layer, and thicknesses of the first layer and the second layer are shown in Table 1.

### Example 9

A reflective photomask blank was obtained by the same manner in Example 1, except that the ratio of silicon and oxygen in the first layer and thickness of the first layer were changed. Compositions of the first layer and the second layer, and thicknesses of the first layer and the second layer are shown in Table 1.

### Example 10

A reflective photomask blank was obtained by the same manner in Example 4, except that the ratio of silicon and oxygen in the first layer and thickness of the first layer, and the ratio of chromium and nitrogen in the second layer and thickness of the second layer were changed. Compositions of the first layer and the second layer, and thicknesses of the first layer and the second layer are shown in Table 1.

### Comparative Example 1

A reflective photomask blank was obtained by the same manner in Example 5, except that a hard mask film that consists of a layer composed of a material containing chromium and free of silicon (which corresponds to a hard mask film consisting of a second layer) was formed on the light-absorbing film. Composition and thickness of the hard mask film are shown in Table 1.

**Table 1**

| | First Layer | | | Second Layer | | | | |
|---|---|---|---|---|---|---|---|---|
| | Composition [at%] | | Thickness [nm] | Composition [at%] | | | | Thickness [nm] |
| | Silicon | Oxygen | | Chromium | Oxygen | Nitrogen | Carbon | |
| Example 1 | 56 | 43 | 12.0 | 85 | 3 | 12 | 0 | 10.0 |
| Example 2 | 34 | 66 | 12.0 | 85 | 3 | 12 | 0 | 10.0 |
| Example 3 | 56 | 43 | 2.0 | 85 | 3 | 12 | 0 | 16.0 |
| Example 4 | 56 | 43 | 2.0 | 51 | 0 | 49 | 0 | 16.0 |
| Example 5 | 56 | 43 | 10.0 | 53 | 28 | 19 | 0 | 10.0 |
| Example 6 | 34 | 66 | 2.0 | 85 | 3 | 12 | 0 | 16.0 |
| Example 7 | 56 | 43 | 10.0 | 33 | 36 | 20 | 11 | 10.0 |
| Example 8 | 56 | 43 | 13.0 | 85 | 3 | 12 | 0 | 10.0 |
| Example 9 | 70 | 30 | 10.0 | 85 | 3 | 12 | 0 | 10.0 |
| Example 10 | 72 | 28 | 13.0 | 95 | 0 | 5 | 0 | 17.0 |
| Comparative Example 1 | - | | | 53 | 28 | 19 | 0 | 3.0 |

### [Etching-Clear-Time in Fluorine-based Dry Etching of First Layer]

With respect to each of the reflective photomask blanks obtained in Examples 1 to 10, a time (clear-time) for which the first layer disappears by fluorine-based dry etching was measured. The clear-time of the fluorine-based dry etching is a time for which an end point is detected (a time until the end point) when the dry etching was performed to the first layer under the following conditions (Condition 1). Results are shown in Table 2.

### [Conditions for Fluorine-based Dry Etching of First Layer (Condition 1)]

System: ICP (Inductively Coupled Plasma) System
Gas: SF₆ gas, O₂ gas and He gas
Gas pressure: 5.0 mTorr (0.66 Pa)
ICP power: 400W

### [Etching-Clear-Time in Chlorine-based Dry Etching of Second Layer]

With respect to each of the reflective photomask blanks obtained Examples 1 to 10 and Comparative Example 1, after measuring the etching-clear-time in fluorine-based dry etching, a time (clear-time) for which the second layer disappears by chlorine-based dry etching was measured. The clear time of the chlorine-based dry etching is a time for which an end point is detected (a time until the end point) when the dry etching was performed to the second layer under the following conditions (Condition 2). Results are shown in Table 2.

### [Conditions for Chlorine-based Dry Etching of Second Layer (Condition 2)]

System: ICP (Inductively Coupled Plasma) System
Gas: Cl₂ gas and O₂ gas
Gas pressure: 3.0 mTorr (0.40 Pa)
ICP power: 350W

**Table 2**

| | Etching-clear-time in Fluorine-based Dry Etching [second] | Etching-clear-time in Chlorine-based Dry Etching [second] |
|---|---|---|
| Example 1 | 19 | 63 |
| Example 2 | 15 | 63 |
| Example 3 | 3 | 100 |
| Example 4 | 3 | 62 |
| Example 5 | 16 | 43 |
| Example 6 | 2 | 100 |
| Example 7 | 16 | 37 |
| Example 8 | 21 | 63 |
| Example 9 | 25 | 63 |
| Example 10 | 34 | 116 |
| Comparative Example 1 | - | 13 |

### [Reduced Amount of Resist Film in Fluorine-based Dry Etching of First Layer]

With respect to each of the reflective photomask blanks obtained in Examples 1 to 10, a reduced amount (thickness) of a resist film until the first layer disappears by fluorine-based dry etching was measured. First, a positive chemically amplified electron beam resist was spin-coated on the first layer to form a resist film having a thickness of 60 nm. Next, a total of 20 isolated line patterns having dimensions of a long side of 100,000 nm and a short side of 60 nm were drawn by an electron beam lithography equipment at a dose of 100 µC/cm². Next, heat treatment (PEB: Post Exposure Bake) was performed by a heat treatment equipment at 115 °C for 14 minutes. Next, puddle development was performed for 42 seconds to form a resist pattern. Next, the first layer was subjected to fluorine-based dry etching with using the resist pattern as an etching mask under Condition 1 described above with 20% over-etching to form a pattern of the first layer. Then, a thickness of the resist pattern remaining on the pattern of the first layer was measured, and a reduced thickness was calculated. Results are shown in Table 3. The thickness of the resist pattern was measured by an atomic force microscope (AFM) within a range of a square area of 200 nm×200 nm as a measured range (the same in the following measurements).

Further, from the obtained reduced amount, a thickness of the resist film required to remain the resist pattern having a thickness of 20 nm after performing the fluorine-based dry etching of the first layer under the condition with 20% over-etching was calculated. Results are shown in Table 3. This thickness is a minimum necessary thickness of the resist film in manufacturing a reflective photomask using each of the reflective photomask blanks of Examples 1 to 10, described later. If the thickness of the resist pattern remaining after etching is too thin, fluorine-based plasma reaches to the first layer and causes pinhole defects. Thus, the thickness of the resist pattern remaining after etching was set to 20 nm in this case.

### [Reduced Amount of First Layer in Chlorine-based Dry Etching of Second Layer]

With respect to each of the reflective photomask blanks obtained in Examples 1 to 10, a reduced amount (thickness) of the first layer until the second layer disappears by chlorine-based dry etching was measured. First, a positive chemically amplified electron beam resist was spin-coated on the first layer to form a resist film having a thickness of 60 nm. Next, a total of 20 isolated line patterns having dimensions of a long side of 100,000 nm and a short side of 60 nm were drawn by an electron beam lithography equipment at a dose of 100 µC/cm². Next, heat treatment (PEB: Post Exposure Bake) was performed by a heat treatment equipment at 115 °C for 14 minutes. Next, puddle development was performed for 42 seconds to form a resist pattern. Next, the first layer was subjected to fluorine-based dry etching with using the resist pattern as an etching mask under Condition 1 described above with 20% over-etching to form a pattern of the first layer. Next, the remaining resist pattern was removed by cleaning with a sulfuric acid-hydrogen peroxide mixture (a mixed solution of sulfuric acid and hydrogen peroxide solution in the ratio of sulfuric acid/hydrogen peroxide solution=3/1). Next, the second layer was subjected to chlorine-based dry etching with using the pattern of the first layer as an etching mask under Condition 2 described above with 300% over-etching to form a pattern of the second layer. Then, a thickness of the pattern of the first layer on the pattern of the second layer was measured, and a reduced thickness was calculated. Results are shown in Table 3. The thickness of the first layer was measured by an X-ray diffractometer. As a result, it was confirmed that none of the first layers in the reflective photomask blanks obtained in Examples 1 to 10 completely disappears during the chlorine-based dry etching of the second layer.

### [Reduced Amount of Resist Film in Chlorine-based Dry Etching of Second Layer]

With respect to each of the reflective photomask blank obtained in Comparative Example 1, a reduced amount (thickness) of a resist film until the second layer disappears by chlorine-based dry etching was measured. First, a positive chemically amplified electron beam resist was spin-coated on the second layer to form a resist film having a thickness of 60 nm. Next, a total of 20 isolated line patterns having dimensions of a long side of 100,000 nm and a short side of 60 nm were drawn by an electron beam lithography equipment at a dose of 100 µC/cm². Next, heat treatment (PEB: Post Exposure Bake) was performed by a heat treatment equipment at 115 °C for 14 minutes. Next, puddle development was performed for 42 seconds to form a resist pattern. Next, the second layer was subjected to chlorine-based dry etching with using the resist pattern as an etching mask under Condition 2 described above with 300% over-etching to form a pattern of the second layer. Then, a thickness of the resist pattern remaining on the pattern of the second layer was measured, and a reduced thickness was calculated. Results are shown in Table 3.

Further, from the obtained reduced amount, a thickness of the resist film required to remain the resist pattern having a thickness of 20 nm after performing the chlorine-based dry etching of the second layer under the condition with 300% over-etching was calculated. Results are shown in Table 3. This thickness is a minimum necessary thickness of the resist film in manufacturing a reflective photomask using the reflective photomask blank of Comparative Example 1, described later. If the thickness of the resist pattern remaining after etching is too thin, chlorine-based plasma reaches to the second layer and causes pinhole defects. Thus, the thickness of the resist pattern remaining after etching was set to 20 nm in this case.

**Table 3**

| | Reduced Amount of Resist Film [nm] | Reduced Amount of First Layer [nm] | Necessary Thickness of Resist Film [nm] |
|---|---|---|---|
| Example 1 | 38 | 0.8 | 58 |
| Example 2 | 29 | 1.2 | 49 |
| Example 3 | 6 | 1.2 | 26 |
| Example 4 | 6 | 0.7 | 26 |
| Example 5 | 31 | 0.8 | 51 |
| Example 6 | 5 | 1.9 | 25 |
| Example 7 | 31 | 0.4 | 51 |
| Example 8 | 41 | 0.8 | 61 |
| Example 9 | 50 | 0.6 | 70 |
| Example 10 | 44 | 1.3 | 64 |
| Comparative Example 1 | 41 | - | 61 |

### Examples 11 to 20

A positive chemically amplified electron beam resist was spin-coated on the hard mask film (first layer) of each of the reflective photomask blanks obtained in Examples 1 to 10 to form a resist film. A reflective photomask blank including a resist film (a reflective photomask blank of the second embodiment) as shown in FIG. 2 was obtained. The thickness of this resist film was set to not less than 40 nm that is the lower limit of thickness such that a resist pattern having a thickness of 20 nm will remain after fluorine-based dry etching, as described above, and the resist film can be formed with a stably thickness by the used resist material. The thicknesses of the resist film are shown in Table 4.

To evaluate resolution limit of a fine pattern corresponding to an assist pattern of an isolated line pattern, a reflective photomask was manufactured from the obtained reflective photomask blank including the resist film. First, as a test pattern corresponding to an assist pattern of a line pattern, a total of 200,000 isolated line patterns having dimensions of a long side of 80 nm and a short side of from 20 m to 60 nm which varies by 1 nm, i.e., having a different dimension in the short side were drawn by an electron beam lithography equipment at a dose of 100 µC/cm². Next, heat treatment (PEB: Post Exposure Bake) was performed by a heat treatment equipment at 110 °C for 14 minutes. Next, puddle development was performed for 45 seconds to form a resist pattern. Next, the first layer was subjected to fluorine-based dry etching with using the resist pattern as an etching mask under Condition 1 described above with 20% over-etching to form a pattern of the first layer. Next, the remaining resist pattern was removed by cleaning with a sulfuric acid-hydrogen peroxide mixture (a mixed solution of sulfuric acid and hydrogen peroxide solution in the ratio of sulfuric acid/hydrogen peroxide solution=3/1). Next, the second layer was subjected to chlorine-based dry etching with using the pattern of the first layer as an etching mask under Condition 2 described above with 300% over-etching to form a pattern of the second layer.

Next, the light-absorber film was subjected to fluorine-based dry etching with using the pattern of the second layer as an etching mask under the following conditions (Condition 3) to form a pattern of the light-absorbing film, and the pattern of the first layer was simultaneously removed.

### [Conditions for Fluorine-based Dry Etching of Light-absorbing Film (Condition 3)]

System: ICP (Inductively Coupled Plasma) System
Gas: SF₆ gas and He gas
Gas pressure: 4.0 mTorr (0.53 Pa)
ICP power: 400W

Next, the pattern of the second layer was subjected to chlorine-based dry etching under Condition 2 described above with 50% over-etching to remove the pattern of the second layer, then a reflective photomask was obtained.

Next, resolution limit of the test pattern of the obtained photomask was evaluated by a visual inspection device. All isolated patterns were evaluated for pattern disappearance, pattern collapse, and pattern shape defects, and an isolated pattern having any of pattern disappearance, pattern collapse, and pattern shape defects detected by the visual inspection device was regarded as a defect, and the resolution limit was evaluated as the minimum dimension of the short side of the isolated pattern without the defect. Results are shown in Table 4.

### Comparative Example 2

A positive chemically amplified electron beam resist was spin-coated on the hard mask film of the reflective photomask blank obtained in Comparative Example 1 to form a resist film. The thickness of this resist film was set to not less than 40 nm that is the lower limit of thickness such that a resist pattern having a thickness of 20 nm will remain after chlorine-based dry etching, as described above, and the resist film can be formed with a stably thickness by the used resist material. The thicknesses of the resist film are shown in Table 4.

To evaluate resolution limit of a fine pattern corresponding to an assist pattern of an isolated line pattern, a reflective photomask was manufactured from the obtained reflective photomask blank including the resist film. First, a resist pattern was formed by the same manner in Examples. Next, the hard mask film was subjected to chlorine-based dry etching with using the resist pattern as an etching mask under Condition 2 described above with 300% over-etching to form a pattern of the hard mask film. Next, the remaining resist pattern was removed by cleaning with a sulfuric acid-hydrogen peroxide mixture (a mixed solution of sulfuric acid and hydrogen peroxide solution in the ratio of sulfuric acid/hydrogen peroxide solution=3/1).

Next, the light-absorber film was subjected to fluorine-based dry etching with using the pattern of the hard mask film as an etching mask under Condition 3 described above to form a pattern of the light-absorbing film.

Next, the pattern of the hard mask film was subjected to chlorine-based dry etching under Condition 2 described above with 50% over-etching to remove the pattern of the hard mask film, then a reflective photomask was obtained, and resolution limit of the test pattern was evaluated by a visual inspection device by the same manner in Examples. Result is shown in Table 4.

### Examples 21 to 30 and Comparative Example 3

A resist film formed on the hard mask film was removed by cleaning with a sulfuric acid-hydrogen peroxide mixture, and then the resist was formed again to evaluate resolution limit of a fine pattern corresponding to an assist pattern of an isolated line pattern. A reflective photomask was obtained by the same manner in each of Examples 11 to 20 and Comparative Example 2 except that the resist film formed on the hard mask film of each of the reflective photomask blanks obtained in Examples 1 to 10 and Comparative Example 1 was once removed by cleaning with a sulfuric acid-hydrogen peroxide mixture, and a resist pattern was formed after forming a resist film again on the hard mask film. Then, resolution limit of the test pattern was evaluated by the same manner in Examples. Results are shown in Table 4.

**Table 4**

| Reflective Photomask Blank | Thickness of Resist Film [nm] | Resolution Limit [nm] | | | |
|---|---|---|---|---|---|
| Example 1 | 58 | Example 11 | 25 | Example 21 | 25 |
| Example 2 | 49 | Example 12 | 25 | Example 22 | 25 |
| Example 3 | 40 | Example 13 | 22 | Example 23 | 22 |
| Example 4 | 40 | Example 14 | 22 | Example 24 | 22 |
| Example 5 | 51 | Example 15 | 24 | Example 25 | 24 |
| Example 6 | 40 | Example 16 | 22 | Example 26 | 22 |
| Example 7 | 51 | Example 17 | 24 | Example 27 | 24 |
| Example 8 | 61 | Example 18 | 28 | Example 28 | 28 |
| Example 9 | 70 | Example 19 | 36 | Example 29 | 36 |
| Example 10 | 64 | Example 20 | 29 | Example 30 | 29 |
| Comparative Example 1 | 61 | Comparative Example 2 | 34 | Comparative Example 3 | 80 |

In each of the hard mask films in the reflective photomask blanks of Examples 1 to 10, the first layer composed of a material containing silicon and free of chromium is disposed at the side remotest from the substrate. Therefore, as disclosed in Table 4, it is confirmed that the sulfuric acid-hydrogen peroxide mixture used for removing the resist film on the hard mask film does not influence the first layer in each Examples 21 to 30, and each of the resolution limits in Examples 21 to 30 does not change from each of the resolution limits in Examples 11 to 20. It is considered that this is because adhesion of the first layer of the hard mask film in each of the reflective photomask blanks of Examples 1 to 10 to the resist film did not deteriorate by cleaning with the sulfuric acid-hydrogen peroxide mixture. On the other hand, the hard mask film in the reflective photomask blank of Comparative Example 1 is composed of a material containing chromium and free of silicon. It was confirmed that the sulfuric acid-hydrogen peroxide mixture used for removing the resist film on the hard mask film influences the resolution limit, and the resolution limit in Comparative Example 3 deteriorates compared with the resolution limit in Comparative Example 2. It is considered that this is because adhesion of the hard mask film composed of a material containing chromium and free of silicon in the reflective photomask blank of Comparative Example 1 to the resist film deteriorated by cleaning with the sulfuric acid-hydrogen peroxide mixture.

Typically, it is confirmed that the resist film can be thinned in each of the reflective photomask blanks in Examples 1 to 7 compared with the resist film in the reflective photomask blank in Comparative Example 1, and good resolution limit is obtained. It is considered that this is because collapse of the assist pattern by impact of a developing solution or impact of pure water during rinsing process in the developing process for forming a resist pattern was reduced by the thin resist film even when the pattern having a narrow width is used.

Further, each of the reflective photomask blanks of Examples 1 to 7 can be used a thin resist film compared with the reflective photomask blanks of Examples 9 and 10. This is because each of the silicon contents of the first layers in Examples 1 to 7 is lower than each of the silicon contents of the first layers in Examples 9 and 10. Furthermore, it is confirmed that in the reflective photomask blank of Example 8, although the thickness of the resist film was the same as that of the reflective photomask blank of Comparative Example 1, a better resolution limit was obtained compared with in Comparative Example 1.

The invention is not limited to the above embodiment. The above-described embodiment is an example, and any other embodiments having the same or substantially the same configuration as the technical idea of the invention and having the same or similar effects can be regarded as the invention included in the scope of the inventive technical range.

## Claims

1. A reflective photomask blank comprising
a substrate,
a multilayer reflection film that is formed on the substrate and reflects exposure light being light in extreme ultraviolet range,
a protection film that is formed on the multilayer reflection film to protect the multilayer reflection film,
a light-absorbing film that is formed on the protection film and absorbs the exposure light, and
a hard mask film that is formed on and in contact with the light-absorbing film and functions as a hard mask in pattering the light-absorbing film by dry etching, wherein
the hard mask film is constituted by a multilayer comprising a first layer and a second layer, the first layer is disposed at the side remotest from the substrate,
the first layer is composed of a material comprising silicon and free of chromium, and
the second layer is composed of a material comprising chromium and free of silicon.

2. The reflective photomask blank of claim 1 wherein the material of the first layer further comprises oxygen, and has a silicon content of not less than 25 at% and not more than 65 at%, and an oxygen content of not less than 30 at%.

3. The reflective photomask blank of claim 1 or 2 wherein the first layer has a thickness of not less than 2 nm and not more than 12 nm.

4. The reflective photomask blank of any one of claims 1 to 3 wherein the material of the second layer further comprises nitrogen, and has a chromium content of not less than 30 at% and not more than 90 at%, and a nitrogen content of not less than 8 at% and not more than 55 at%.

5. The reflective photomask blank of any one of claims 1 to 4 wherein the material of the second layer further comprises oxygen, and has an oxygen content of not more than 40 at%.

6. The reflective photomask blank of any one of claims 1 to 5 wherein the material of the second layer further comprises carbon, and has a carbon content of not more than 20 at%.

7. The reflective photomask blank of any one of claims 1 to 6 wherein the second layer has a thickness of not less than 2 nm and not more than 16 nm.

8. The reflective photomask blank of any one of claims 1 to 7 wherein the light-absorbing film is composed of a material comprising tantalum.

9. The reflective photomask blank of any one of claims 1 to 8 wherein the light-absorbing film has a thickness of not less than 50 nm and not more than 74 nm.

10. The reflective photomask blank of any one of claims 1 to 9 comprising a resist film that is formed on and in contact with the hard mask film and has a thickness of not more than 80 nm.

11. A method for manufacturing a reflective photomask comprising a pattern of the light-absorbing film from the reflective photomask blank of any one of claims 1 to 9, wherein the method comprises the steps of
(A) forming a resist film in contact with the hard mask film at the side remotest from the substrate,
(B) patterning the resist film to form a resist pattern,
(C) patterning the first layer to form a pattern of the first layer by dry etching using a fluorine-based gas with utilizing the resist pattern as an etching mask,
(D) removing the resist pattern,
(E) patterning the second layer to form a pattern of the second layer by dry etching using a chlorine-based gas with utilizing the pattern of the first layer as an etching mask,
(F) patterning the light-absorbing film to form a pattern of the light-absorbing film by dry etching using a fluorine-based gas with utilizing the pattern of the second layer as an etching mask, and simultaneously removing the pattern of the first layer, and
(G) removing the pattern of the second layer by dry etching using a chlorine-based gas.

12. The method of claim 11 wherein the resist film has a thickness of not more than 80 nm.

13. The method of claim 11 or 12 wherein the pattern of the light-absorbing film comprises line patterns having a width of not more than 25 nm.

14. A method for manufacturing a reflective photomask comprising a pattern of the light-absorbing film from the reflective photomask blank of claim 10, wherein the method comprises the steps of:
(B) patterning the resist film to form a resist pattern,
(C) patterning the first layer to form a pattern of the first layer by dry etching using a fluorine-based gas with utilizing the resist pattern as an etching mask,
(D) removing the resist pattern,
(E) patterning the second layer to form a pattern of the second layer by dry etching using a chlorine-based gas with utilizing the pattern of the first layer as an etching mask,
(F) patterning the light-absorbing film to form a pattern of the light-absorbing film by dry etching using a fluorine-based gas with utilizing the pattern of the second layer as an etching mask, and simultaneously removing the pattern of the first layer, and
(G) removing the pattern of the second layer by dry etching using a chlorine-based gas.

15. The method of claim 14 wherein the resist film has a thickness of not more than 80 nm.

16. The method of claim 14 or 15 wherein the pattern of the light-absorbing film comprises line patterns having a width of not more than 25 nm.

17. A reflective photomask comprising
a substrate,
a multilayer reflection film that is formed on the substrate and reflects exposure light being light in extreme ultraviolet range,
a protection film that is formed on the multilayer reflection film to protect the multilayer reflection film, and
a pattern of a light-absorbing film that is formed on the protection film and absorbs the exposure light, wherein
the pattern of the light-absorbing film comprises line patterns having a width of not more than 25 nm.
